# EUROPEAN PATENT APPLICATION

(11) **EP 4 682 291 A1**
(43) Date of publication of application: **21.01.2026**
(21) Application number: 25183019.6
(22) Date of filing: 16.06.2025
(51) Int. Cl.: C23C 14/52, C23C 14/54, C23C 14/56

(54) **APPARATUS FOR MANUFACTURING PANEL AND METHOD FOR MANUFACTURING PANEL USING THE SAME**

(30) Priority: 25.06.2024 KR 20240083089
(71) Applicant: Samsung Display Co., Ltd., Yongin-si, Gyeonggi-do 17113 (KR)
(72) Inventor: HUCH, Sungmin, Yongin-si (KR); KIM, Inhwan, Yongin-si (KR); KIM, Jinwoo, Yongin-si (KR); KIM, Hojoong, Yongin-si (KR); PARK, Jae-Heung, Yongin-si (KR); BAEK, Chulhyun, Yongin-si (KR); SHIN, Yong-sik, Yongin-si (KR); LEE, Byeongchun, Yongin-si (KR); LEE, Hojin, Yongin-si (KR); JO, Seongwoo, Yongin-si (KR)
(74) Representative: Marks & Clerk LLP

(57) **Abstract**

An apparatus for manufacturing a panel includes a first process chamber in which a first inorganic layer is deposited on a substrate to cover a display element layer disposed on the substrate, a second process chamber which receives the substrate, on which the first inorganic layer is deposited, so that an organic layer is printed on the first inorganic layer, a third process chamber which receives the substrate, on which the organic layer is printed, so that a second inorganic layer is deposited on the organic layer, and a layer thickness measuring device disposed between the first process chamber and the second process chamber to measure a thickness of the first inorganic layer when the substrate is transferred from the first process chamber to the second process chamber.

## Description

### BACKGROUND

### 1. Field

The disclosure herein relates to an apparatus for manufacturing a panel and a method for manufacturing a panel using the same.

### 2. Description of the Related Art

In general, a display device includes a display panel on which an image is displayed. The display panel includes a substrate, a circuit element layer disposed on the substrate, a display element layer disposed on the circuit element layer, and a thin film encapsulation layer that covers the display element layer. The circuit element layer includes a plurality of transistors, and the display element layer includes a plurality of light-emitting elements connected to the transistors. The light-emitting elements are driven by the transistors to generate predetermined light, thereby displaying an image.

The thin film encapsulation layer protects the light-emitting elements from foreign substances such as moisture, oxygen, and dust particles. The thin film encapsulation layer includes a first inorganic layer, an organic layer, and a second inorganic layer, which are laminated sequentially. During the process of manufacturing the display panel, after the thin film encapsulation layer is formed, thicknesses of the first inorganic layer, the organic layer, and the second inorganic layer are measured. The thicknesses of the first inorganic layer, the organic layer, and the second inorganic layer are measured by a layer thickness measuring device.

An ellipsometer may be used as the layer thickness measuring device. The ellipsometer may measure optical characteristics such as a thickness and refractive index of a thin film by utilizing polarization properties of light.

### SUMMARY

The disclosure provides an apparatus for manufacturing a panel, which is capable of measuring a thickness of a first inorganic layer immediately after the first inorganic layer of a thin film encapsulation layer is formed on a substrate, and a method for manufacturing a panel using the same.

An embodiment of the inventive concept provides an apparatus for manufacturing a panel including a substrate, a display element layer on the substrate and a first inorganic layer on the display element layer, the apparatus including: a first process chamber configured for deposition of a first inorganic layer on a substrate to cover a display element layer disposed on the substrate; a second process chamber configured to receive the substrate, on which the first inorganic layer is deposited, and the second process chamber configured for printing an organic layer on the first inorganic layer; a third process chamber configured to receive the substrate, on which the organic layer is printed, and the third process chamber configured for deposition of a second inorganic layer on the organic layer; and a layer thickness measuring device disposed between the first process chamber and the second process chamber and configured to measure a thickness of the first inorganic layer when the substrate is transferred from the first process chamber to the second process chamber.

In an embodiment of the inventive concept, a method for manufacturing a panel includes: depositing a first inorganic layer on a substrate to cover a display element layer disposed on the substrate; measuring a thickness of the first inorganic layer; comparing the thickness of the first inorganic layer with a target thickness; controlling a deposition amount of next first inorganic layer disposed on a next substrate; printing an organic layer on the first inorganic layer; and depositing a second inorganic layer on the organic layer.

In an embodiment of the inventive concept, an apparatus for manufacturing a panel includes: a first process chamber configured for deposition of a first inorganic layer on a substrate to cover a display element layer disposed on the substrate; a second process chamber configured to receive the substrate, on which the first inorganic layer is deposited, and the second process chamber configured for printing an organic layer on the first inorganic layer; a third process chamber configured to receive the substrate, on which the organic layer is printed, and the third process chamber configured for deposition of a second inorganic layer on the organic layer; a transfer chamber disposed between the first process chamber and the second process chamber to provide a transfer passage for the substrate; and a layer thickness measuring device connected to the transfer chamber and configured to measure a thickness of the first inorganic layer on the substrate when disposed within the transfer chamber.

At least some of the above and other features of the invention are set out in the claims.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1 is a schematic view illustrating an embodiment of a configuration of an apparatus for manufacturing a panel according to the inventive concept;
FIG. 2 is a plan view of a mother substrate provided in the apparatus for manufacturing the panel illustrated in FIG. 1;
FIG. 3 is a cross-sectional view taken along line I-I' of FIG. 2;
FIGS. 4A to 4C are views illustrating processes of forming a thin film encapsulation layer on the mother substrate illustrated in FIG. 3;
FIG. 5 is a cross-sectional view of a display panel formed by cutting a unit substrate illustrated in FIG. 4C;
FIG. 6 is a plan view of the display panel illustrated in FIG. 5;
FIG. 7 is a view illustrating an embodiment of a cross-section of one pixel illustrated in FIG. 6;
FIG. 8 is a perspective view of a display device including the display panel illustrated in FIG. 5;
FIG. 9 is a view illustrating an embodiment of a cross-section of the display device illustrated in FIG. 8;
FIG. 10 is a perspective view of a layer thickness measuring device illustrated in FIG. 1;
FIG. 11 is a perspective view of a first transfer chamber and layer thickness measuring devices disposed on the first transfer chamber illustrated in FIG. 1;
FIG. 12 is a plan view of the first transfer chamber and the layer thickness measuring devices when the first transfer chamber and the layer thickness measuring devices illustrated in FIG. 11 are viewed from the above;
FIG. 13 is a cross-sectional view taken along line II-II' of FIG. 11;
FIG. 14 is a plan view of a mother substrate illustrated in FIG. 13 when viewed from the above;
FIG. 15 is a view illustrating a cross-section of one tag illustrated in FIG. 14 and side views of first and second lens parts and a position measuring part, which are disposed on the tag;
FIG. 16 is a flowchart illustrating a method for manufacturing a panel using the apparatus for manufacturing the panel , which is illustrated in FIG. 1;
FIGS. 17 and 18 are view illustrating another embodiment of an arrangement of layer thickness measuring devices according to the inventive concept;
FIG. 19 is a view illustrating another embodiment of a dummy chamber disposed on a transfer chamber according to the inventive concept; and
FIG. 20 is a view illustrating the inside of the transfer chamber and the dummy chamber illustrated in FIG. 19.

### DETAILED DESCRIPTION

In this specification, it will also be understood that when one component (or region, layer, portion) is referred to as being "on", "connected to", or "coupled to" another component, it may be directly disposed/connected/coupled on/to the one component, or an intervening third component may also be present.

Like reference numerals refer to like elements throughout. Also, in the drawing figures, the thickness, ratio, and dimensions of components are exaggerated for clarity of illustration.

The term "and/or" includes any and all combinations of one or more of the associated listed items.

It will be understood that although the terms such as 'first' and 'second' are used herein to describe various elements, these elements should not be limited by these terms. The terms are only used to distinguish one component from other components. For example, a first element referred to as a first element in an embodiment can be referred to as a second element in another embodiment without departing from the scope of the appended claims. The terms of a singular form may include plural forms unless referred to the contrary.

Also, "under", "below", "above', "upper", and the like are used for explaining relation association of components illustrated in the drawings. The terms may be a relative concept and described based on directions expressed in the drawings.

Unless otherwise defined, all terms (including technical and scientific terms) used herein have the same meaning as commonly understood by a person of ordinary skill in the art to which this invention belongs. In addition, terms such as those defined in commonly used dictionaries should be interpreted as having meanings consistent with their meanings in the context of the relevant technology, and unless explicitly defined, it should not be interpreted in an overly idealistic or overly formal sense.

The meaning of 'include' or 'comprise' specifies a property, a fixed number, a step, an operation, an element, a component or a combination thereof, but does not exclude other properties, fixed numbers, steps, operations, elements, components or combinations thereof.

Hereinafter, embodiments of the inventive concept will be described with reference to the accompanying drawings.

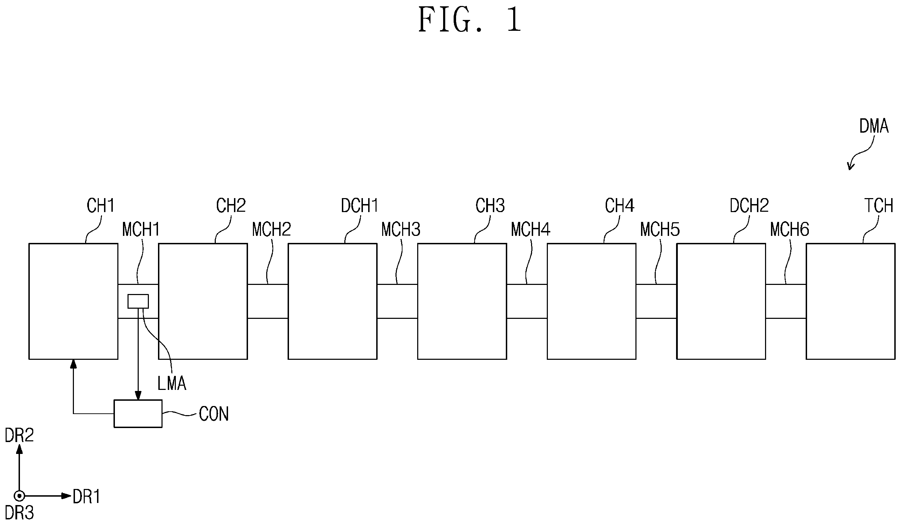

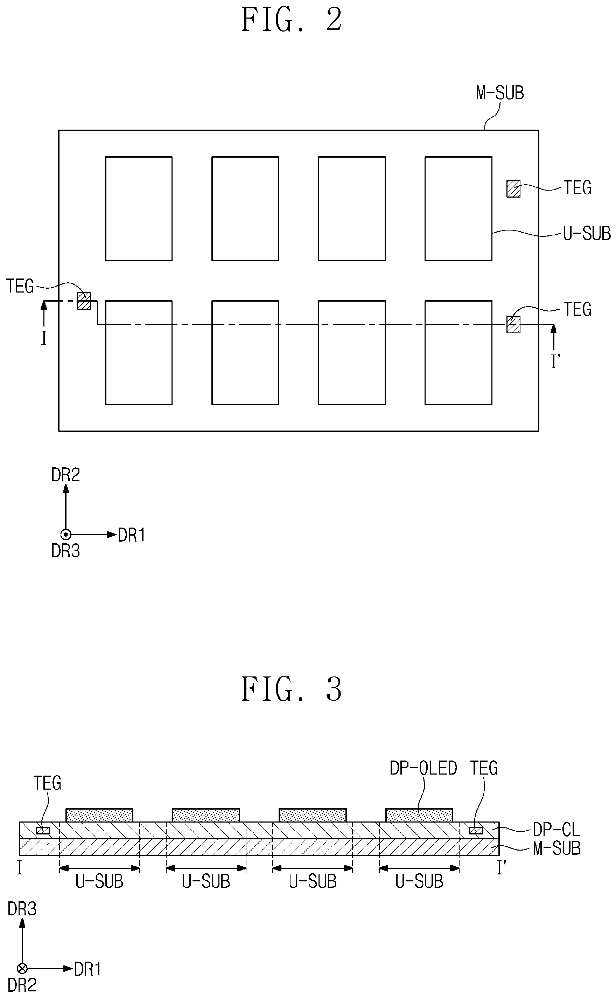

FIG. 1 is a schematic view illustrating an embodiment of a configuration of an apparatus for manufacturing a panel according to the inventive concept. FIG. 2 is a plan view of a mother substrate provided in the apparatus for manufacturing the panel illustrated in FIG. 1. FIG. 3 is a cross-sectional view taken along line I-I' of FIG. 2.

FIG. 1 illustrates an apparatus DMA for manufacturing a panel in a plan view, for example. The plane may be defined by a first direction DR1 and a second direction DR2, which perpendicularly intersect each other. In addition, the state when viewed in the plan view may be defined as a state when viewed in a third direction DR3 that intersects perpendicularly with the plane defined by the first and second directions DR1 and DR2.

Referring to FIG. 1, the apparatus DMA for manufacturing the panel may include a first process chamber CH1, a second process chamber CH2, a third process chamber CH3, a fourth process chamber CH4, a layer thickness measuring device (e.g., layer thickness measuring circuitry) LMA, a first inspection chamber DCH1, a second inspection chamber DCH2, a layer thickness measuring chamber TCH, a plurality of first to sixth transfer chambers MCH1 to MCH6, and a controller CON.

The first, second, and third process chambers CH1, CH2, and CH3, the first and second inspection chambers DCH1 and DCH2, and the layer thickness measuring chamber TCH may be arranged in the first direction DR1 in order of the first process chamber CH1, the second process chamber CH2, the first inspection chamber DCH1, the third process chamber CH3, the fourth process chamber CH4, the second inspection chamber DCH2, and the layer thickness measuring chamber TCH.

The first transfer chamber MCH1 may be disposed between the first process chamber CH1 and the second process chamber CH2 and may be connected to the first process chamber CH1 and the second process chamber CH2. The first transfer chamber MCH1 may provide a transfer space for transferring a substrate, on which a process is performed in the first process chamber CH1, to the second process chamber CH2.

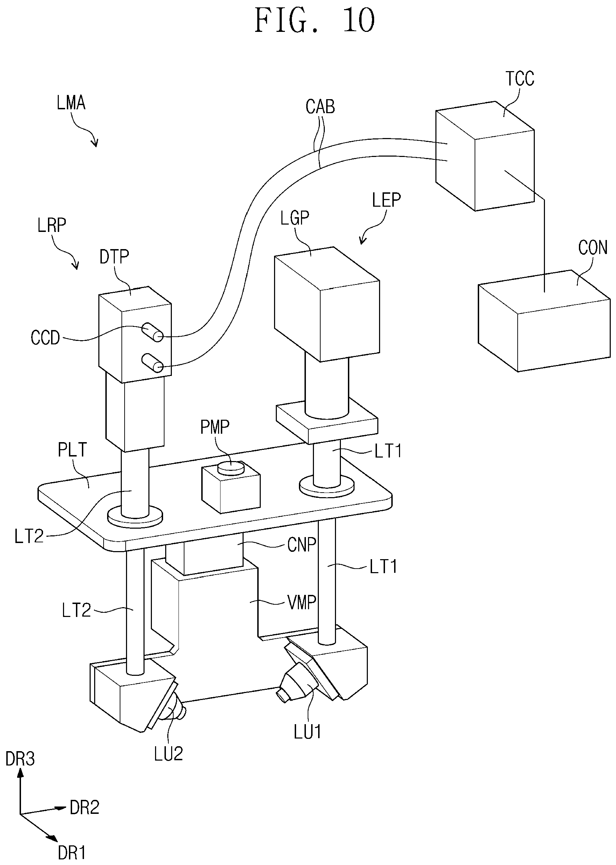

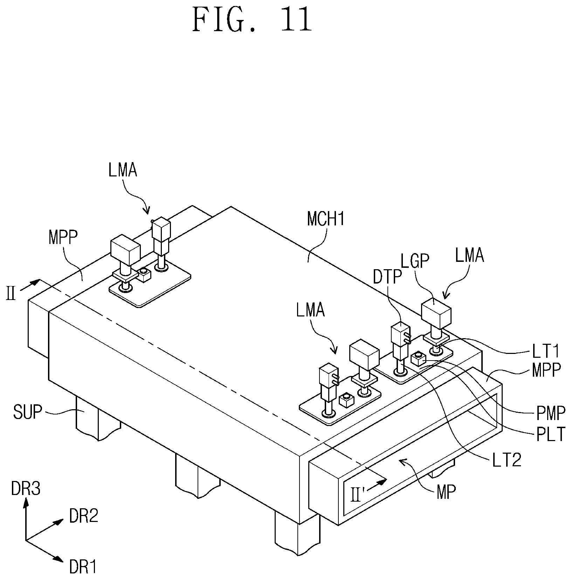

The layer thickness measuring device LMA may be disposed between the first process chamber CH1 and the second process chamber CH2. The layer thickness measuring device LMA may be disposed on the first transfer chamber MCH1. The layer thickness measuring device LMA may be connected to the first transfer chamber MCH1. FIG. 1 is a schematic block diagram of the layer thickness measuring device LMA, and a more detailed configuration and arrangement position of the layer thickness measuring device LMA will be described below in detail in FIGS. 10 and 11.

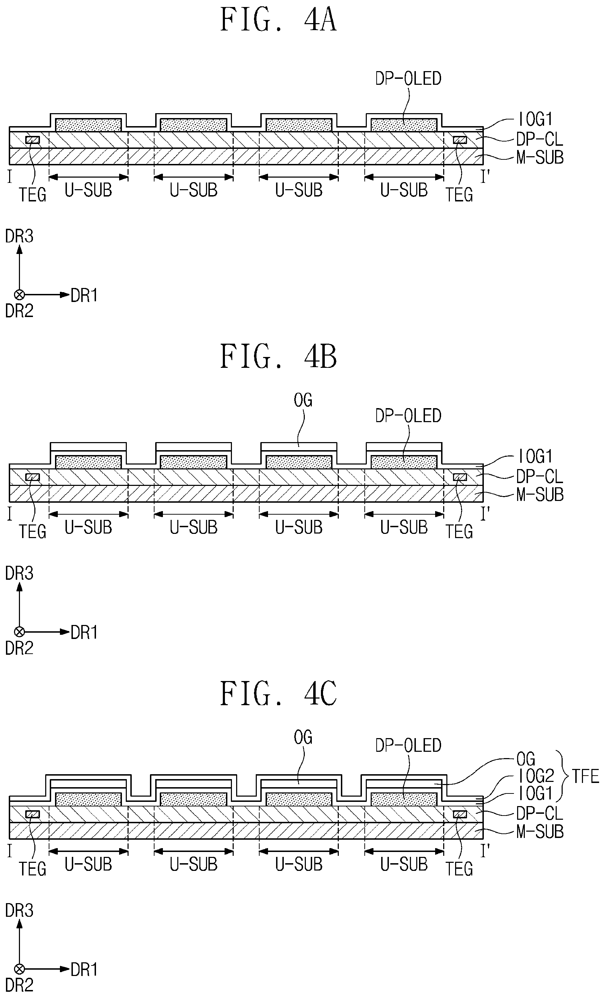

The controller CON may receive thickness information measured from the layer thickness measuring device LMA and may control the process performed in the first process chamber CH1 according to the thickness information. This operation will be described below in detail in FIG. 4A.

The second transfer chamber MCH2 may be disposed between the second process chamber CH2 and the first inspection chamber DCH1 and may be connected to the second process chamber CH2 and the first inspection chamber DCH1. The second transfer chamber MCH2 may provide a transfer space for transferring a substrate, on which a process is performed in the second process chamber CH2, to the first inspection chamber DCH1.

The third transfer chamber MCH3 may be disposed between the first inspection chamber DCH1 and the third process chamber CH3 and may be connected to the first inspection chamber DCH1 and the third process chamber CH3. The third transfer chamber MCH3 may provide a transfer space for transferring a substrate, which is inspected in the first inspection chamber DCH1, to the third process chamber CH3.

The fourth transfer chamber MCH4 may be disposed between the third process chamber CH3 and the fourth process chamber CH4 and may be connected to the third process chamber CH3 and the fourth process chamber CH4. The fourth transfer chamber MCH4 may provide a transfer space for transferring a substrate, on which a process is performed in the third process chamber CH3, to the fourth process chamber CH4.

The fifth transfer chamber MCH5 may be disposed between the fourth process chamber CH4 and the second inspection chamber DCH2 and may be connected to the fourth process chamber CH4 and the second inspection chamber DCH2. The fifth transfer chamber MCH5 may provide a transfer space for transferring a substrate, on which a process is performed in the fourth process chamber CH4, to the second inspection chamber DCH2.

The sixth transfer chamber MCH6 may be disposed between the second inspection chamber DCH2 and the layer thickness measuring chamber TCH and may be connected to the second inspection chamber DCH2 and the layer thickness measuring chamber TCH. The sixth transfer chamber MCH6 may provide a transfer space for transferring a substrate, which is inspected in the second inspection chamber DCH2, to the layer thickness measuring chamber TCH.

Referring to FIGS. 2 and 3, a mother substrate M-SUB may have a quadrangular shape, e.g., rectangular shape having long sides extending in the first direction DR1 and short sides extending in the second direction DR2. However, the shape of the mother substrate M-SUB is not limited thereto.

The mother substrate M-SUB may include a plurality of unit substrates U-SUB. Each of the unit substrates U-SUB may have a quadrangular shape, e.g., rectangular shape having short sides extending in the first direction DR1 and long sides extending in the second direction DR2. However, the shape of the unit substrates U-SUB is not limited thereto.

In an embodiment, eight unit substrates U-SUB arranged in two rows and four columns are illustrated, for example, but the number of unit substrates U-SUB is not limited thereto. The rows may correspond to the first direction DR1 and the columns may correspond to the second direction DR2.

A circuit element layer DP-CL may be disposed on the mother substrate M-SUB. A plurality of display element layers DP-OLED may be disposed on the circuit element layer DP-CL. The display element layers DP-OLED may be respectively arranged on the unit substrates U-SUB.

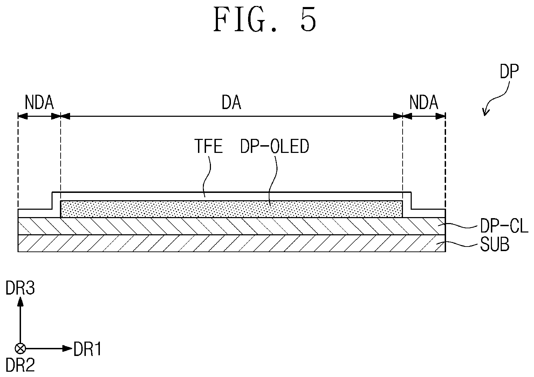

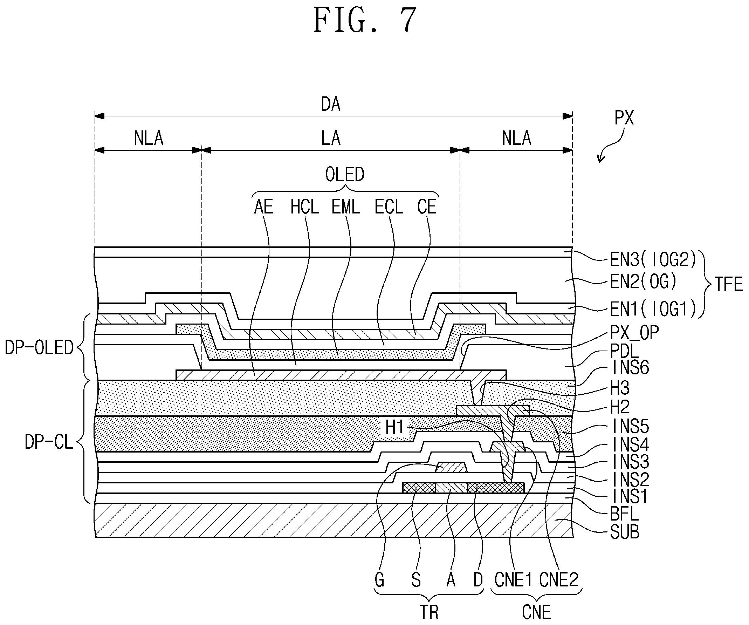

The circuit element layer DP-CL may include transistors as driving elements. The display element layers DP-OLED may include light-emitting elements connected to the transistors. This configuration will be described below in detail in FIGS. 5 and 7.

A plurality of tags TEG may be disposed on the mother substrate M-SUB. In an embodiment, three tags TEG are illustrated in FIG. 2, for example, but the number of tags TEG is not limited thereto. In an embodiment, at least one tag TEG may be disposed on the mother substrate M-SUB, for example.

The tags TEG may be disposed within the circuit element layer DP-CL. When viewed in the plan view, the tags TEG may not overlap the display element layers DP-OLED. When viewed in the plan view, the tags TEG may be next (adjacent) to an edge of the mother substrate M-SUB.

The tags TEG may be next (adjacent) to opposite sides of the mother substrate M-SUB opposing each other in the first direction DR1. Both the sides of the mother substrate M-SUB opposing each other in the first direction DR1 may extend in the second direction DR2. One tag TEG may be next (adjacent) to one side of both the sides of the mother substrate M-SUB, and two tags TEG may be next (adjacent) to an opposite side of both the sides of the mother substrate M-SUB, but the arrangement positions of the tags TEG are not limited thereto.

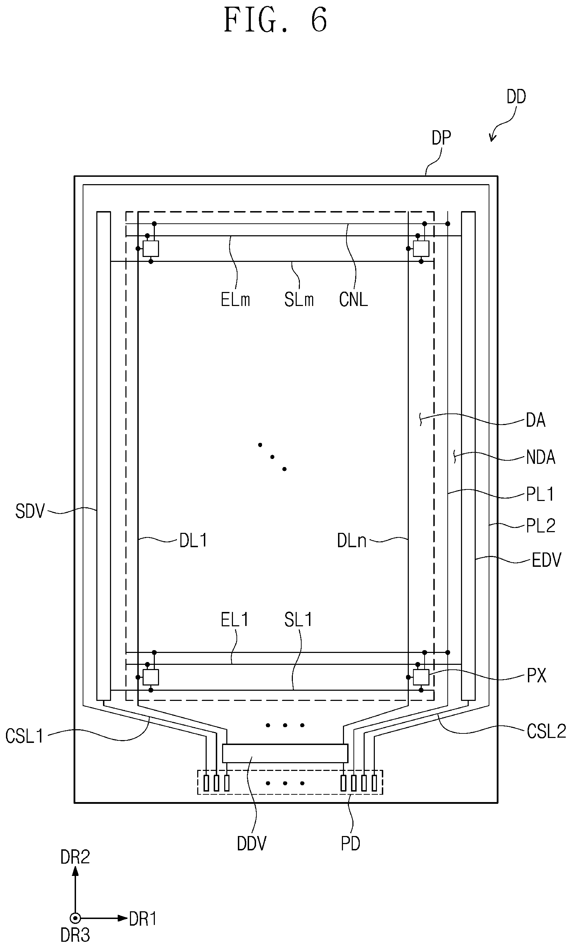

Although not shown, after the process for the mother substrate M-SUB is completed, portions overlapping the edges of the unit substrates U-SUB may be cut. The portions overlapping the edges of the unit substrates U-SUB may be cut to provide display panels. The configuration of the display panel will be described below in detail in FIG. 6.

Referring to FIGS. 1, 2, and 3, the mother substrate M-SUB may be transferred from the first process chamber CH1 to the layer thickness measuring chamber TCH. As the mother substrate M-SUB is transferred from the first process chamber CH1 to the layer thickness measuring chamber TCH, the thin film encapsulation layer (which is illustrated below in FIGS. 4A to 4C) may be disposed on the mother substrate M-SUB, an inspection process may be performed on the mother substrate M-SUB, and a thickness of the thin film encapsulation layer may be measured.

FIGS. 4A to 4C are views illustrating processes of forming the thin film encapsulation layer on the mother substrate illustrated in FIG. 3.

Referring to FIGS. 1, 3, and 4A, the mother substrate M-SUB illustrated in FIG. 3 may be provided to the first process chamber CH1. In the first process chamber CH1, a first inorganic layer IOG1 may be provided on the mother substrate M-SUB. The first inorganic layer IOG1 may be deposited on the mother substrate M-SUB to cover the display element layers DP-OLED. The first inorganic layer IOG1 may be disposed on the tags TEG. The first process chamber CH1 may be defined as a deposition chamber.

The first inorganic layer IOG1 may be deposited on the mother substrate M-SUB through a chemical vapor deposition ("CVD") process. Although not shown, a deposition facility for performing the chemical vapor deposition may be disposed within the first process chamber CH1 so that the deposition process for the first inorganic layer IOG1 is performed. The chemical vapor deposition process is a general process that is known to those skilled in the art, and thus, its description will be omitted.

Although not shown, the first inorganic layer IOG1 may include at least one inorganic layer. In an embodiment, the first inorganic layer IOG1 may be provided on the mother substrate M-SUB as a single layer, for example, but is not limited thereto, and may be provided on the mother substrate M-SUB as a plurality of inorganic layers. That is, the first inorganic layer IOG1 may include a plurality of inorganic layers.

Referring to FIG. 1 and FIG. 4A, the mother substrate M-SUB on which the first inorganic layer IOG1 is deposited may be transferred from the first process chamber CH1 to the second process chamber CH2 through the first transfer chamber MCH1.

When the mother substrate M-SUB is transferred from the first process chamber CH1 to the second process chamber CH2, the layer thickness measuring device LMA connected to the first transfer chamber MCH1 may measure a thickness of the first inorganic layer IOG1. The layer thickness measuring device LMA may measure the thickness of the first inorganic layer IOG1 on the mother substrate M-SUB disposed within the first transfer chamber MCH1.

The layer thickness measuring device LMA may include an ellipsometer. The layer thickness measuring device LMA may be provided in plural, and the plurality of layer thickness measuring devices LMA will be illustrated below in FIG. 11.

When the thickness of the first inorganic layer IOG1 is measured in the first transfer chamber MCH1, the next first inorganic layer may be deposited on the next mother substrate in the first process chamber CH1. Hereinafter, for convenience of explanation, the next substrate and the next first inorganic layer will be referred to by the same symbols as those illustrated in FIGS. 2 and 3.

The thickness of the first inorganic layer IOG1 measured by the layer thickness measuring device LMA may be provided to the controller CON. The controller CON may control a deposition amount of next first inorganic layer IOG1 performed in the first process chamber CH1 according to the thickness of the first inorganic layer IOG1 disposed in the first transfer chamber MCH1.

The controller CON may compare the measured thickness of the first inorganic layer IOG1 with a target thickness as information stored therein. The first inorganic layer IOG1 has to be formed to the target thickness, but when the first inorganic layer IOG1 is not formed to the target thickness, the deposition amount for next first inorganic layer IOG1 to be manufactured may be controlled.

The controller CON may reduce the deposition amount of next first inorganic layer IOG1 deposited on the next mother substrate M-SUB in the first process chamber CH1 when the measured thickness of the first inorganic layer IOG1 is greater than the target thickness. In an embodiment, the controller CON may control the deposition facility so that the deposition amount of first inorganic layer IOG1 provided on the substrate from the deposition facility disposed in the first process chamber CH1 is reduced, for example.

The controller CON may allow the deposition amount of next first inorganic layer IOG1 deposited on the next mother substrate M-SUB in the first process chamber CH1 to increase when the measured thickness of the first inorganic layer IOG1 is less than the target thickness. In an embodiment, the controller CON may control the deposition facility so that the deposition amount of first inorganic layer IOG1 provided on the substrate from the deposition facility disposed in the first process chamber CH1 increases, for example.

The thickness of the next first inorganic layer IOG1 may be determined depending on the deposition amount. Thus, the deposition amount of next first inorganic layer IOG1 may be controlled to control the thickness of the next first inorganic layer IOG1.

Referring to FIG. 1 and FIGS. 4A and 4B, the second process chamber CH2 may receive the mother substrate M-SUB on which the first inorganic layer IOG1 is deposited through the first transfer chamber MCH1. In the second process chamber CH2, an organic layer OG may be provided on the first inorganic layer IOG1. The organic layer OG may be provided on each of the display element layers DP-OLED.

The organic layer OG may be provided on the first inorganic layer IOG1 through inkjet printing. Although not shown, an inkjet printing facility for performing the inkjet printing process may be disposed within the second process chamber CH2. The inkjet printing process is a common process that is known to those skilled in the art, and thus, its description will be omitted.

Referring to FIG. 1 and FIG. 4B, the mother substrate M-SUB on which the organic layer OG is printed may be transferred from the second process chamber CH2 to the first inspection chamber DCH1 through the second transfer chamber MCH2.

The inspection of the organic layer OG may be performed in the first inspection chamber DCH1. In an embodiment, an image of the organic layer OG may be captured through an inspection camera, and the captured image may be used to inspect whether the organic layer OG is applied normally or applied abnormally, for example.

Thereafter, the mother substrate M-SUB on which the organic layer OG is printed may be transferred from the first inspection chamber DCH1 to the third process chamber CH3 through the third transfer chamber MCH3.

Referring to FIG. 1 and FIGS. 4B and 4C, the third process chamber CH3 may receive the mother substrate M-SUB, on which an organic layer OG is printed, through the third transfer chamber MCH3. In the third process chamber CH3, a second inorganic layer IOG2 may be provided on the organic layer OG. The third process chamber CH3 may be defined as a deposition chamber.

The second inorganic layer IOG2 may be deposited on the mother substrate M-SUB through the chemical vapor deposition process. Although not shown, a deposition facility for performing the chemical vapor deposition may be disposed within the third process chamber CH3.

The first inorganic layer IOG1, the organic layer OG, and the second inorganic layer IOG2 may be defined as the thin film encapsulation layer TFE. That is, the thin film encapsulation layer TFE may include the first inorganic layer IOG1, the organic layer OG, and the second inorganic layer IOG2. The first inorganic layer IOG1 may be defined as a first encapsulation layer, the organic layer OG may be defined as a second encapsulation layer, and the second inorganic layer IOG2 may be defined as a third encapsulation layer.

Referring to FIG. 1, the mother substrate M-SUB on which the second inorganic layer IOG2 is deposited may be transferred from the third process chamber CH3 to the fourth process chamber CH4 through the fourth transfer chamber MCH4. In the fourth process chamber CH4, an annealing process for the mother substrate M-SUB may be performed. In the fourth process chamber CH4, the mother substrate M-SUB may be heated and then cooled.

Thereafter, the mother substrate M-SUB may be transferred from the fourth process chamber CH4 to the second inspection chamber DCH2 through the fifth transfer chamber MCH5. In the second inspection chamber DCH2, foreign substance inspection (or particle inspection) with respect to the components DP-CL, DP-OLED, IOG1, OG, and IOG2 disposed on the mother substrate M-SUB may be performed.

The inspection may be performed by auto optical inspection ("AOI") equipment. Whether contaminant particles exist in the components DP-CL, DP-OLED, IOG1, OG, and IOG2 disposed on the mother substrate M-SUB may be inspected through the AOI equipment.

Thereafter, the mother substrate M-SUB may be transferred from the second inspection chamber DCH2 to the layer thickness measuring chamber TCH through the sixth transfer chamber MCH6. The above-described layer thickness measuring devices LMA may be disposed inside the layer thickness measuring chamber TCH.

The thickness of the first inorganic layer IOG1 has been measured by the layer thickness measuring device LMA connected to the first transfer chamber MCH1, but the thicknesses of the organic layer OG and the second inorganic layer IOG2 have not yet been measured. The above-described layer thickness measuring devices LMA may be disposed inside the layer thickness measuring chamber TCH to measure the thicknesses of the organic layer OG and the second inorganic layer IOG2. The layer thickness measuring devices LMA disposed within the layer thickness measuring chamber TCH may also include an ellipsometer.

FIG. 5 is a cross-sectional view of the display panel formed by cutting a unit substrate illustrated in FIG. 4C.

Referring to FIGS. 4C and 5, portions overlapping the edges of the unit substrates U-SUB may be cut, and thus, a display panel (also referred to as a panel) DP corresponding to each of the unit substrates U-SUB may be provided.

The display panel DP may include a substrate SUB, a circuit element layer DP-CL disposed on the substrate SUB, a display element layer DP-OLED disposed on the circuit element layer DP-CL, and a thin film encapsulation layer TFE disposed on the display element layer DP-OLED. The thin film encapsulation layer TFE may include a first inorganic layer IOG1, an organic layer OG, and a second inorganic layer IOG2.

The substrate SUB may include a display area DA and a non-display area NDA around the display area DA. The substrate SUB may include glass or a flexible plastic material such as polyimide ("PI"). The display element layer DP-OLED may be disposed on the display area DA.

A plurality of pixels may be disposed on the circuit element layer DP-CL and the display element layer DP-OLED. Each of the pixels may include a transistor disposed on the circuit element layer DP-CL and a light-emitting element disposed on the display element layer DP-OLED and connected to the transistor.

The thin film encapsulation layer TFE may be disposed on the circuit element layer DP-CL to cover the display element layer DP-OLED. The thin film encapsulation layer TFE may protect the pixels from moisture, oxygen, and external foreign substances.

FIG. 6 is a plan view of the display panel illustrated in FIG. 5.

Referring to FIG. 6, a display device DD may include a display panel DP, a scan driver SDV, a data driver DDV, a light emission driver EDV, and a plurality of pads PD.

The display panel DP may have a quadrangular shape, e.g., rectangular shape with long sides extending in the second direction DR2 and short sides extending in the first direction DR1, but the shape of the display panel DP is not limited thereto. The display panel DP may include a display area DA and a non-display area NDA surrounding the display area DA.

The display panel DP may include a plurality of pixels PX, a plurality of scan lines SL1 to SLm, a plurality of data lines DL1 to DLn, a plurality of light-emitting lines EL1 to ELm, first and second control lines CSL1 and CSL2, first and second power lines PL1 and PL2, and connection lines CNL. Here, m and n are natural numbers.

The pixels PX may be disposed on the display area DA. Each of the scan driver SDV and the light emission driver EDV may be disposed on the non-display area NDA next (adjacent) to each of the long sides of the display panel DP. The data driver DDV may be disposed on the non-display area NDA next (adjacent) to one of the short sides of the display panel DP. When viewed from the plan view, the data driver DDV may be next (adjacent) to a lower end of the display panel DP.

The scan lines SL1 to SLm may extend in the first direction DR1 and be connected to the pixels PX and the scan driver SDV. The data lines DL1 to DLn may extend in the second direction DR2 and be connected to the pixels PX and the data driver DDV. The light-emitting lines EL1 to ELm may extend in the first direction DR1 and be connected to the pixels PX and the light emission driver EDV.

The first power line PL1 may extend in the second direction DR2 and may be disposed on the non-display area NDA. The first power line PL1 may be disposed between the display area DA and the light emission driver EDV.

The connection lines CNL may extend in the first direction DR1 and be arranged in the second direction DR2 so as to be connected to the first power line PL1 and the pixels PX. A first voltage may be applied to the pixels PX through the first power line PL1 and the connection lines CNL, which are connected to each other.

The second power line PL2 may be disposed on the non-display area NDA to extend along the long sides of the display panel DP and another short side of the display panel DP, on which the data driver DDV is not disposed. The second power line PL2 may be disposed outside the scan driver SDV and the light emission driver EDV.

Although not shown, the second power line PL2 may extend toward the display area DA and be connected to the pixels PX. A second voltage having a level lower than that of the first voltage may be applied to the pixels PX through the second power line PL2.

The first control line CSL1 may be connected to the scan driver SDV to extend toward a lower end of the display panel DP. The second control line CSL2 may be connected to the light emission driver EDV to extend toward the lower end of the display panel DP. The data driver DDV may be disposed between the first control line CSL1 and the second control line CSL2.

The pads PD may be disposed on the non-display area NDA next (adjacent) to the lower end of the display panel DP and may be closer to the lower end of the display panel DP than the data driver DDV. The data driver DDV, the first power line PL1, the second power line PL2, the first control line CSL1, and the second control line CSL2 may be connected to the pads PD. The data lines DL1 to DLn may be connected to the data driver DDV, and the data driver DDV may be connected to pads PD corresponding to the data lines DL1 to DLn.

Although not shown, the display device DD may further include a timing controller that controls operations of the scan driver SDV, the data driver DDV, and the light emission driver EDV and a voltage generator that generates the first and second voltages. The timing controller and the voltage generator may be connected to the pads PD through a printed circuit board.

The scan driver SDV may generate a plurality of scan signals, and the scan signals may be applied to the pixels PX through the scan lines SL1 to SLm. The data driver DDV may generate a plurality of data voltages, and the data voltages may be applied to the pixels PX through the data lines DL1 to DLn. The light emission driver EDV may generate a plurality of light emission signals, and the light emission signals may be applied to the pixels PX through the light-emitting lines EL1 to ELm.

The pixels PX may receive the data voltages in response to the scan signals. The pixels PX may emit light having brightness corresponding the data voltages in response to the light emission signals to display an image.

FIG. 7 is a view illustrating an embodiment of a cross-section of one pixel illustrated in FIG. 6.

Referring to FIG. 7, the pixel PX may include a transistor TR and a light-emitting element OLED. The light-emitting element OLED may include a first electrode AE (or anode), a second electrode CE (or cathode), a hole control layer HCL, an electron control layer ECL, and an emission layer EML.

The transistor TR and the light-emitting element OLED may be disposed on the substrate SUB. Although one transistor TR is illustrated in an embodiment, in practice, the pixel PX may include a plurality of transistors and at least one capacitor for driving the light-emitting element OLED.

The display area DA may include an emission area LA corresponding to each pixel PX and a non-emission area NLA around the emission area LA. The light-emitting element OLED may be disposed on the emission area LA.

A buffer layer BFL may be disposed on the substrate SUB, and the buffer layer may be an inorganic layer. A semiconductor pattern may be arranged on the buffer layer BFL. The semiconductor pattern may include polysilicon, amorphous silicon, or metal oxide.

The semiconductor pattern may be doped with N-type dopants or P-type dopants. The semiconductor pattern may include a high-doped region and a low-doped region. The high-doped region may have conductivity greater than that of the low-doped region and may practically serve as source and drain electrodes of the transistor TR. The low-doped region may effectively correspond to an active (or channel) of the transistor.

A source S, an active A, and a drain D of the transistor TR may be provided from the semiconductor pattern. A first insulating layer INS1 may be arranged on the semiconductor pattern. A gate G of the transistor TR may be disposed on the first insulating layer INS1. A second insulating layer INS2 may be disposed on the gate G. A third insulating layer INS3 may be disposed on the second insulating layer INS2.

A connection electrode CNE may include a first connection electrode CNE1 and a second connection electrode CNE2 to connect the transistor TR and the light-emitting element OLED. The first connection electrode CNE1 may be disposed on the third insulating layer INS3 and may be connected to the drain D through a first contact hole H1 defined in the first to third insulating layers INS1 to INS3.

The fourth insulating layer INS4 may be disposed on the first connection electrode CNE1. A fifth insulating layer INS5 may be disposed on the fourth insulating layer INS4. The second connection electrode CNE2 may be disposed on the fifth insulating layer INS5. The second connection electrode CNE2 may be connected to the first connection electrode CNE1 through a second contact hole H2 defined in the fourth and fifth insulating layers INS4 and INS5.

The above-described tags TEG may be simultaneously including or consisting of the same material as that of the first connection electrode CNE1 and disposed in the same layer as the first connection electrode CNE1. However, this embodiment is not limited thereto, and the above-described tags TEG may be simultaneously including or consisting of the same material as that of the second connection electrode CNE2 and disposed in the same layer as the second connection electrode CNE2.

A sixth insulating layer INS6 may be disposed on the second connection electrode CNE2. The layers from the buffer layer BFL to the sixth insulating layer INS6 may be defined as the circuit element layer DP-CL. Each of the first insulating layer INS1 to the sixth insulating layer INS6 may be an inorganic layer or an organic layer.

The first electrode AE may be disposed on the sixth insulating layer INS6. The first electrode AE may be connected to the second connection electrode CNE2 through a third contact hole H3 defined in the sixth insulating layer INS6. A pixel defining layer PDL in which an opening PX_OP exposing a predetermined portion of the first electrode AE is defined may be disposed on the first electrode AE and the sixth insulating layer INS6.

The hole control layer HCL may be disposed on the first electrode AE and the pixel defining layer PDL. The hole control layer HCL may include a hole transport layer and a hole injection layer.

The emission layer EML may be disposed on the hole control layer HCL. The emission layer EML may be disposed on an area corresponding to the opening PX_OP. The emission layer EML may include organic and/or inorganic materials. The emission layer EML may emit one of red light, green light, and blue light.

The electron control layer ECL may be disposed on the emission layer EML and the hole control layer HCL. The electron control layer ECL may include an electron transport layer and an electron injection layer. The hole control layer HCL and the electron control layer ECL may be commonly disposed on the emission area (also referred to as a light-emitting region) LA and the non-emission area (also referred to as a non-light-emitting region) NLA.

The second electrode CE may be disposed on the electron control layer ECL. The second electrode CE may be commonly disposed on the pixels PX. The layer on which the light-emitting element OLED is disposed may be defined as the display element layer DP-OLED.

The thin film encapsulation layer TFE may be disposed on the second electrode CE to cover the pixel PX. The thin film encapsulation layer TFE may include a first encapsulation layer EN1 disposed on the second electrode CE, a second encapsulation layer EN2 disposed on the first encapsulation layer EN1, and a third encapsulation layer EN3 disposed on the second encapsulation layer EN2.

Each of the first and third encapsulation layers EN1 and EN3 may include an inorganic insulating layer to protect the pixel PX from moisture/oxygen. The second encapsulation layer EN2 may include an organic insulating layer to protect the pixel PX from foreign substances such as dust particles.

A first voltage may be applied to the first electrode AE through the transistor TR, and a second voltage having a lower level than the first voltage may be applied to the second electrode CE. When holes and electrons injected into the emission layer EML are coupled to provide excitons, the light-emitting element OLED may emit light when the excitons are transited to the ground state.

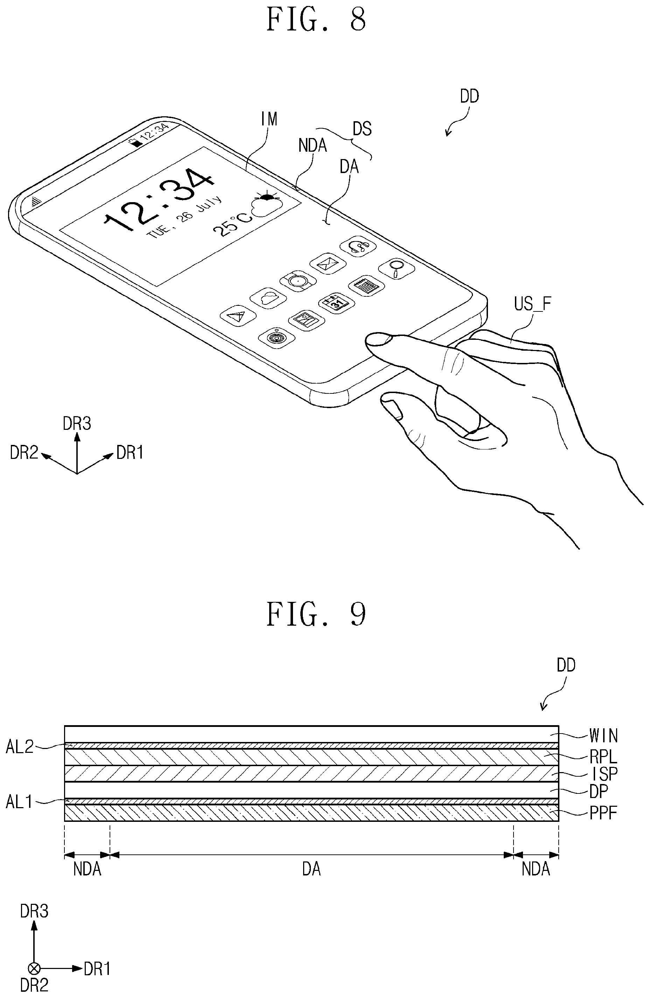

FIG. 8 is a perspective view of the display device including the display panel illustrated in FIG. 5. FIG. 9 is a view illustrating an embodiment of a cross-section of the display device illustrated in FIG. 8.

FIG. 9 illustrates a cross-section of the display device DD when viewed in the second direction DR2, for example.

Referring to FIG. 8, the display device DD in an embodiment of the inventive concept may have a quadrangular shape, e.g., rectangular shape having long sides extending in the second direction DR2 and short sides extending in the first direction DR1. However, this embodiment is not limited thereto, and the display device DD may have various shapes such as circular and polygonal shapes.

A top surface of the display device DD may be defined as a display surface DS and have a plane defined by the first direction DR1 and the second direction DR2. Images IM generated from the display device DD may be provided to a user through the display surface DS. The display device DD may sense a user's touch through the user's hand US_F.

The display surface DS may include a display area DA and a non-display area NDA surrounding the display area DA. The display area DA may display an image, and the non-display area NDA may not display an image. The non-display area NDA may surround the display area DA to define an edge of the display device DD, which is printed with a predetermined color.

Referring to FIG. 9, the display device DD may include a display panel DP, an input sensing part ISP, an anti-reflection layer RPL, a window WIN, a panel protection film PPF, and first and second adhesion layers AL1 and AL2.

The display panel DP may be a flexible display panel. The display panel DP in an embodiment of the inventive concept may be an emission type display panel. In an embodiment, the display panel DP may be an organic light-emitting display panel or an inorganic light-emitting display panel, for example. An emission layer of the organic light-emitting display panel may include an organic light-emitting material. An emission layer of the inorganic light-emitting display panel may include a quantum dot, a quantum rod, or the like.

The input sensing part ISP may be disposed on the display panel DP. The input sensing part ISP may include a plurality of sensing parts (not shown) that sense an external input in a capacitive manner. The input sensing part ISP may be manufactured directly on the display panel DP during the manufacturing of the display device DD. However, this embodiment is not limited thereto, and the input sensing part ISP may be manufactured as a separate panel from the display panel DP and attached to the display panel DP by an adhesion layer.

The anti-reflection layer RPL may be disposed on the input sensing part ISP. The anti-reflection layer RPL may be manufactured directly on the input sensing part ISP during the manufacturing of the display device DD. However, this embodiment is not limited thereto, the anti-reflection layer RPL may be manufactured as a separate panel and attached to the input sensing part ISP by an adhesion layer.

The anti-reflection layer RPL may be defined as an external light anti-reflection film. The anti-reflection layer RPL may reduce reflectance of external light incident from an upper side of the display device DD toward the display panel DP. The external light may not be visible to the user due to the anti-reflection layer RPL.

When the external light directed toward the display panel DP is reflected by the display panel DP and provided again to an external user, the user may recognize the external light, like a mirror. To prevent this phenomenon, e.g., the anti-reflection layer RPL may include a plurality of color filters that display the same color as the pixels of the display panel DP.

The color filters may filter the external light to the same color as the pixels. In this case, the external light may not be visible to the user. However, this embodiment is not limited thereto, and the anti-reflection layer RPL may include a retarder and/or a polarizer to reduce the reflectance of the external light.

The window WIN may be disposed on the anti-reflection layer RPL. The windows WIN may protect the display panel DP, the input sensing part ISP, and the anti-reflection layer RPL from external scratches and impacts.

The panel protection film PPF may be disposed below the display panel DP. The panel protection film PPF may protect a lower portion of the display panel DP. The panel protection film PPF may include a flexible plastic material such as polyethyleneterephthalate ("PET").

The first adhesion layer AL1 may be disposed between the display panel DP and the panel protection film PPF, and the display panel DP and the panel protection film PPF may be bonded to each other by the first adhesion layer AL1. The second adhesion layer AL2 may be disposed between the window WIN and the anti-reflection layer RPL, and the window WIN and the anti-reflection layer RPL may be bonded to each other by the second adhesion layer AL2.

FIG. 10 is a perspective view of the layer thickness measuring device illustrated in FIG. 1.

Referring to FIG. 10, the layer thickness measuring device LMA may include a light irradiation part LEP, a light-receiving part LRP, a thickness analysis part (e.g., thickness analysis circuitry) TCC, a position measuring part (e.g., thickness analysis circuitry) PMP, a plate PLT, a connection part CNP, and a vertical movement part VMP.

The light irradiation part LEP may generate polarized light to irradiate the light onto a sample (e.g., an object to be measured). The light-receiving part LRP may receive the light reflected from a sample to detect an intensity of the received reflected light. The sample for the layer thickness measuring device LMA connected to the first transfer chamber MCH1 may be the first inorganic layer IOG1.

The light irradiation part LEP may include a light generation part LGP, a first light transmission part LT1, and a first lens part LU1. The light generation part LGP may generate light. The light generation part LGP may include a lamp for generating light.

The first light transmission part LT1 may transmit light to the first lens part LU1. Although not shown, the first light transmission part LT1 may polarize light by including a polarizer. The polarizer may not be included in the first light transmission part LT1, but may be included in the light generation part LGP. The first light transmission part LT1 may transmit the polarized light to the first lens part LU1. The first lens part LU1 may provide light to a surface of the sample.

The light reflected from the sample surface may be changed in its polarization state. The reflected light having the changed polarization state may be provided to the light-receiving part LRP.

The light-receiving part LRP may include a second lens part LU2, a second light transmission part LT2, and a detection part DTP. The second lens part LU2 may receive the light reflected from the sample. The second lens part LU2 may be defined as a receiving lens.

The reflected light received from the second lens part LU2 may be provided to the detection part DTP through the second light transmission part LT2. Although not shown, the second light transmission part LT2 may include an analyzer. Since the analyzer rotates around an axis parallel to an optical axis, the polarized light reflected from the sample may be guided to the rotating analyzer, and the reflected light passing through the analyzer may be provided to the detection part DTP.

The detection part DTP may detect the intensity of the reflected light. The detection part DTP may include a charge coupled device CCD. The detection part DTP may be connected to the thickness analysis part TCC through a cable CAB.

Detected information may be provided to the thickness analysis part TCC, and the thickness analysis part TCC may calculate ellipsometry coefficients Ψ and Δ based on the detected information to calculate a thickness of the sample. The thickness analysis part TCC may be an information processing device such as a personal computer ("PC") or server. The thickness of the sample calculated from the thickness analysis part TCC may be provided to the controller CON.

The plate PLT may have a plane defined by first and second directions DR1 and DR2. The light generation part LGP and the detection part DTP may be disposed on the plate PLT. The first and second lens parts LU1 and LU2 may be disposed below the plate PLT.

The first light transmission part LT1 and the second light transmission part LT2 may extend in the third direction DR3 by passing through the plate PLT. The first light transmission part LT1 may be disposed between the light generation part LGP and the first lens part LU1 and may be connected to the light generation part LGP and the first lens part LU1. The second light transmission part LT2 may be disposed between the detection part DTP and the second lens part LU2 and may be connected to the detection part DTP and the second lens part LU2.

The position measuring part PMP may be disposed on the plate PLT. The position measuring part PMP may be disposed between the first light transmission part LT1 and the second light transmission part LT2. The position measuring part PMP may include a camera. The position measuring part PMP may measure a position of the sample disposed below the plate PLT through a hole defined in the plate PLT (not shown in FIG. 10).

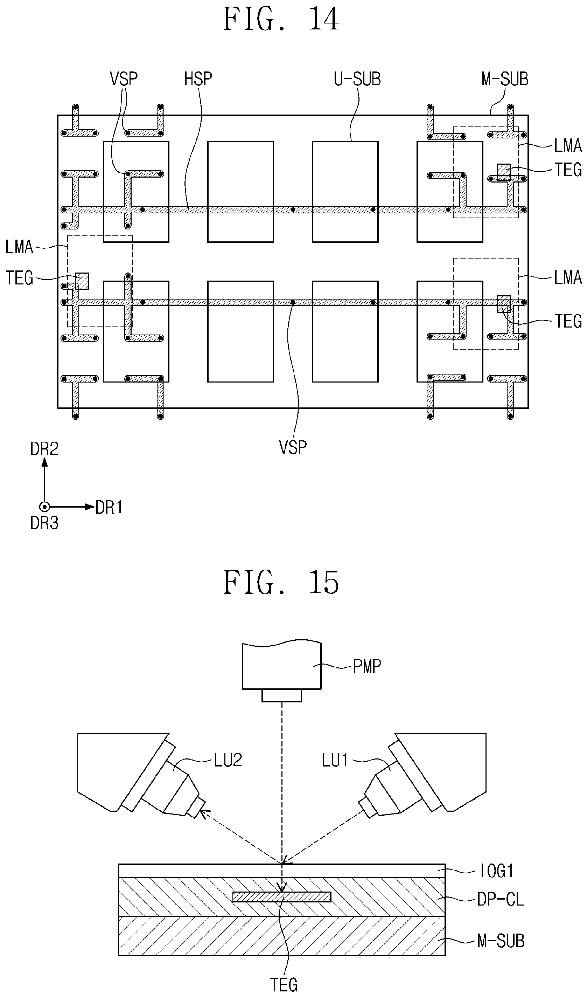

The position of the sample may be identified by the position measuring part PMP. The position of the sample may be aligned to a normal position based on the position measured by the position measuring part PMP. In an embodiment, the position of the sample may be aligned so that light is irradiated toward the tags defined on the sample, for example. The alignment operation of the sample using the tags will be described below in FIG. 15.

The connection part CNP may be disposed below the plate PLT and be connected to the plate PLT. The vertical movement part VMP may be coupled to the connection part CNP to reciprocate in the third direction DR3 with respect to the connection part CNP. In addition, the vertical movement part VMP may be connected to the first and second lens parts LU1 and LU2. Thus, the first and second lens parts LU1 and LU2 may reciprocally move in the third direction DR3 according to the movement of the vertical movement part VMP.

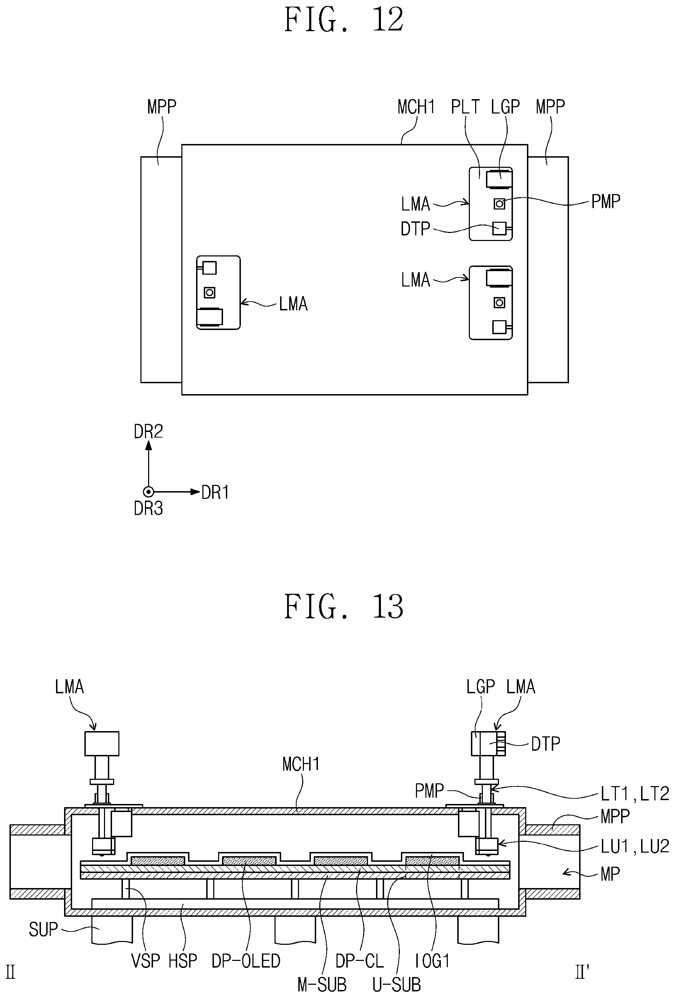

FIG. 11 is a perspective view of the first transfer chamber and the layer thickness measuring devices disposed on the first transfer chamber illustrated in FIG. 1. FIG. 12 is a plan view of the first transfer chamber and the layer thickness measuring devices when the first transfer chamber and the layer thickness measuring devices illustrated in FIG. 11 are viewed from the above;

Referring to FIGS. 11 and 12, the above-described layer thickness measuring device LMA may be provided in plural as shown in FIGS. 11 and 12. The plurality of layer thickness measuring devices LMA may be disposed on the first transfer chamber MCH1. The layer thickness measuring devices LMA may be connected to a top surface of the first transfer chamber MCH1. In an embodiment, each plate PLT of the layer thickness measuring devices LMA may be connected to the top surface of the first transfer chamber MCH1, for example.

The layer thickness measuring devices LMA may be disposed substantially to pass through the first transfer chamber MCH1. In an embodiment, each of the layer thickness measuring devices LMA on the plate PLT may be disposed on the first transfer chamber MCH1, and each of the layer thickness measuring devices LMA below the plate PLT may be disposed within the first transfer chamber MCH1, for example. This configuration will be described below in detail in the cross-sectional view shown in FIG. 13.

When viewed in the plan view, the first transfer chamber MCH1 may have a quadrangular shape, e.g., rectangular shape having long sides extending in the first direction DR1 and short sides extending in the second direction DR2. The first transfer chamber MCH1 may have a hexahedral shape. The first transfer chamber MCH1 may extend longer in the first direction DR1 than in the third direction DR3, longer in the first direction DR1 than in the second direction DR2, and longer in the second direction DR2 than in the third direction DR3.

Transfer passage parts MPP may be connected to both opposite side surfaces of the first transfer chamber MCH1 in the first direction DR1. The transfer passage parts MPP may define transfer passages MP of the mother substrate M-SUB from the first process chamber CH1 to the first transfer chamber MCH1, and from the first transfer chamber MCH1 to the second process chamber CH2.

A plurality of supports SUP extending in the third direction DR3 may be disposed below the first transfer chamber MCH1. The supports SUP may be connected to the first transfer chamber MCH1 to support the first transfer chamber MCH1.

When viewed in the plan view, the layer thickness measuring devices LMA may be next (adjacent) to the edge of the first transfer chamber MCH1 on the top surface of the first transfer chamber MCH1. When viewed in the plan view, the layer thickness measuring devices LMA may be next (adjacent) to opposite sides of the first transfer chamber MCH1, which are opposite to each other in the first direction DR1 and extend in the second direction DR2. The layer thickness measuring devices LMA disposed on both the sides of the first transfer chamber MCH1 may be disposed symmetrically in the first direction DR1.

In an embodiment, three layer thickness measuring devices LMA may be disposed on the first transfer chamber MCH1, for example, but the number of layer thickness measuring devices LMA is not limited thereto. In addition, one layer thickness measuring device LMA may be disposed at one side of the first transfer chamber MCH1, and two layer thickness measuring devices LMA may be disposed at an opposite side of the first transfer chamber MCH1, but the arrangement positions of the layer thickness measuring devices LMA are not limited thereto.

For convenience of explanation, the thickness analysis part TCC illustrated in FIG. 10 is omitted in FIGS. 11 and 12. However, the thickness analysis parts TCC illustrated in FIG. 10 are also provided in plural, and the plurality of thickness analysis parts TCC may be respectively connected to the layer thickness measuring devices LMA illustrated in FIG. 11 to calculate the thickness of the sample.

FIG. 13 is a cross-sectional view taken along line II-II' of FIG. 11. FIG. 14 is a plan view of the mother substrate illustrated in FIG. 13 when viewed from the above. FIG. 15 is a view illustrating a cross-section of one tag illustrated in FIG. 14 and side views of the first and second lens parts and the position measuring part, which are disposed on the tag.

In an embodiment, in FIG. 14, the layer thickness measuring devices LMA are illustrated as dotted quadrangular, e.g., rectangular boxes, for example.

Referring to FIGS. 13 and 14, in an internal space of the first transfer chamber MCH1, horizontal support bars HSP and vertical support bars VSP extending in the third direction DR3 from the horizontal support bars HSP may be disposed on a bottom surface of the first transfer chamber MCH1. The horizontal support bars HSP may extend in a horizontal direction and have a predetermined shape. In an embodiment, the horizontal support bars HSP may extend by being bent at least once in the first direction DR1 and the second direction DR2, for example.

The mother substrate M-SUB may be transferred into the first transfer chamber MCH1. The mother substrate M-SUB may be disposed on the vertical support bars VSP. The vertical support bars VSP may support the mother substrate M-SUB from a lower side of the mother substrate M-SUB.

Since the plates PLT of the layer thickness measuring devices LMA are connected to the top surface of the first transfer chamber MCH1, upper portions of the layer thickness measuring devices LMA may be disposed on the first transfer chamber MCH1. In addition, lower portions of the layer thickness measuring devices LMA may be disposed within the first transfer chamber MCH1.

The light generation parts LGP and the detection parts DTP of the layer thickness measuring devices LMA may be disposed on the first transfer chamber MCH1. That is, the light generation parts LGP and the detection parts DTP may be disposed outside the first transfer chamber MCH1. The first and second lens parts LU1 and LU2 of the layer thickness measuring devices LMA may be disposed within the first transfer chamber MCH1. The first and second light transmission parts LT1 and LT2 may be disposed to pass through the top surface of the first transfer chamber MCH1.

The layer thickness measuring devices LMA may be disposed on the mother substrate M-SUB. The layer thickness measuring devices LMA may be individually disposed on the tags TEG. When viewed in the plan view, the layer thickness measuring devices LMA may overlap the tags TEG to correspond to the tags TEG, respectively. As described above, the first inorganic layer IOG1 may include a plurality of inorganic layers, in this case, the layer thickness measuring devices LMA may measure thicknesses of the inorganic layers. The first and second lens parts LU1 and LU2 may be disposed on the tags TEG.

The layer thickness measuring devices LMA may measure thicknesses of portions of the first inorganic layer IOG1, which overlap the tags TEG. In an embodiment of the inventive concept, the sample described in relation to FIG. 10 may be portions of the first inorganic layer IOG1, which overlap the tags TEG in FIG. 14. The thicknesses of the portions of the first inorganic layer IOG1, which overlap the tags TEG, may be calculated and provided to the controller CON.

Referring to FIG. 15, a position of the tag TEG may be measured by the position measuring part PMP. The position of the tag TEG may be aligned depending on the position of the measured tag TEG. In an embodiment, the position of the tag TEG may be aligned to be disposed between the first lens part LU1 and the second lens part LU2 when viewed in the plan view, for example. That is, the position of the tag TEG may be aligned to a normal position.

The first lens part LU1 may irradiate the polarized light PL generated from the above-described light generation part LGP toward the first inorganic layer IOG1 on the tag TEG. The second lens part LU2 may receive light RL reflected from the first inorganic layer IOG1, and the received light may be provided to the detection part DTP described above.

Referring to FIG. 1 and FIGS. 11 to 14, the controller CON may calculate the thickness of the first inorganic layer IOG1 as an average value of the thicknesses measured from the layer thickness measuring devices LMA. Since the thickness of the first inorganic layer IOG1 is calculated using thicknesses of a plurality of portions rather than a thickness of a single portion, the thickness of the first inorganic layer IOG1 may be calculated more precisely.

As described above, the controller CON may control a deposition amount of next first inorganic layer IOG1 deposited on the next mother substrate M-SUB by comparing the thickness of the first inorganic layer IOG1 with a target thickness. The thickness of the first inorganic layer IOG1 deposited in the first process chamber CH1 may be directly measured to directly control the deposition amount of next first inorganic layer IOG1 through the layer thickness measuring devices LMA.

When the thickness measuring devices LMA are not used, the thickness of the first inorganic layer IOG1 may be measured in the thickness measuring chamber TCH. In this case, the next mother substrate M-SUB may be disposed in each of the second process chamber CH2, the first inspection chamber DCH1, the third process chamber CH3, the fourth process chamber CH4, and the second inspection chamber DCH2.

The thickness of the first inorganic layer IOG1 may be measured in the layer thickness measuring chamber TCH, and the deposition amount of next first inorganic layer IOG1 deposited on the mother substrate M-SUB disposed in the first process chamber CH1 may be controlled. However, since the first inorganic layers IOG1 disposed on the next mother substrate M-SUB disposed in each of the second process chamber CH2, the first inspection chamber DCH1, the third process chamber CH3, the fourth process chamber CH4, and the second inspection chamber DCH2 have already completed the deposition process, the thickness of the first inorganic layers IOG1 may not be controlled in the second process chamber CH2, the first inspection chamber DCH1, the third process chamber CH3, the fourth process chamber CH4, and the second inspection chamber DCH2.

In an embodiment of the inventive concept, the thickness of the first inorganic layer IOG1 deposited in the first process chamber CH1 may be directly measured, and the deposition amount of next first inorganic layer IOG1 in the first process chamber CH1 may be directly controlled to be similar to the target thickness. Thus, the thickness of the first inorganic layer IOG1 may be formed closer to the target thickness. When the first inorganic layer IOG1 includes the plurality of inorganic layers, the thicknesses of the inorganic layers may be measured so that the thickness of the first inorganic layer IOG1 is formed similar to the target thickness.

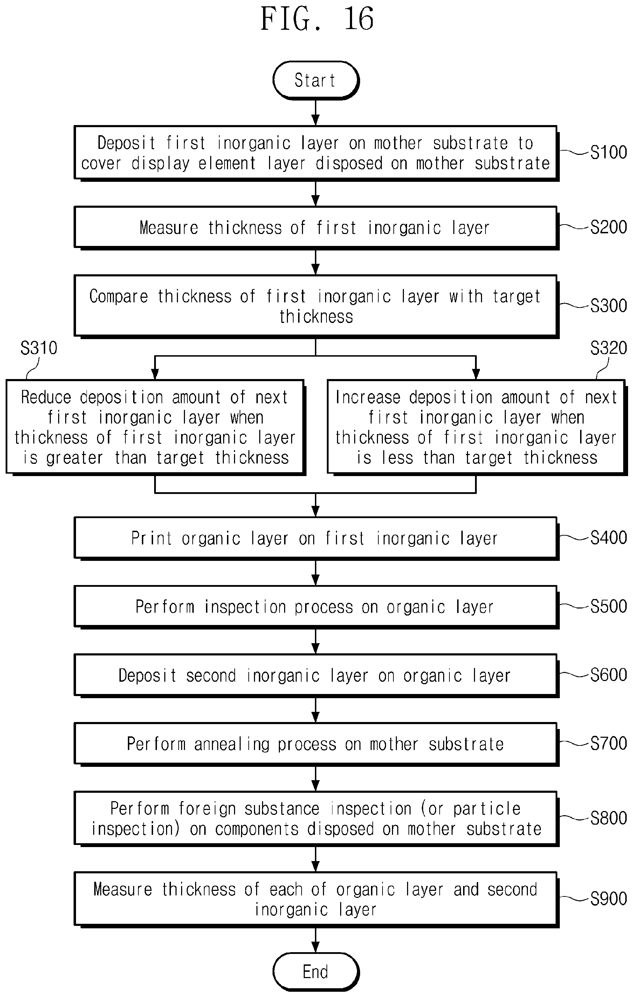

FIG. 16 is a flowchart illustrating a method for manufacturing a panel using the apparatus for manufacturing the panel, which is illustrated in FIG. 1.

Since the detailed operation of the apparatus DMA for manufacturing the panel has been described above, the method for manufacturing the panel will be briefly described below.

Referring to FIG. 16, in operation S100, a first inorganic layer IOG1 may be deposited on a mother substrate M-SUB to cover display element layers DP-OLED disposed on the mother substrate M-SUB.

In operation S200, a thickness of the first inorganic layer IOG1 may be measured by a layer thickness measuring device LMA. In operation S300, the thickness of the first inorganic layer IOG1 and a target thickness may be compared by a controller CON.

In operations S310 and S320, based on the comparison results, a deposition amount of next first inorganic layer IOG1 deposited on the next mother substrate M-SUB may be controlled. In operation S310, when the thickness of the first inorganic layer IOG1 is greater than the target thickness, the controller CON may reduce the deposition amount of next first inorganic layer IOG1. In operation S320, when the thickness of the first inorganic layer IOG1 is less than the target thickness, the controller CON may increase the deposition amount of next first inorganic layer IOG1.

In operation S400, an organic layer OG may be printed on the first inorganic layer IOG1. In operation S500, an inspection process for the organic layer OG may be performed. In operation S600, a second inorganic layer IOG2 may be deposited on the organic layer OG. In operation S700, an annealing process for the mother substrate M-SUB may be performed.

In operation S800, a foreign substance inspection (or particle inspection) may be performed on the components DP-CL, DP-OLED, IOG1, OG, and IOG2 disposed on the mother substrate M-SUB. In operation S900, the thickness of the organic layer OG and the second inorganic layer IOG2 may be measured.

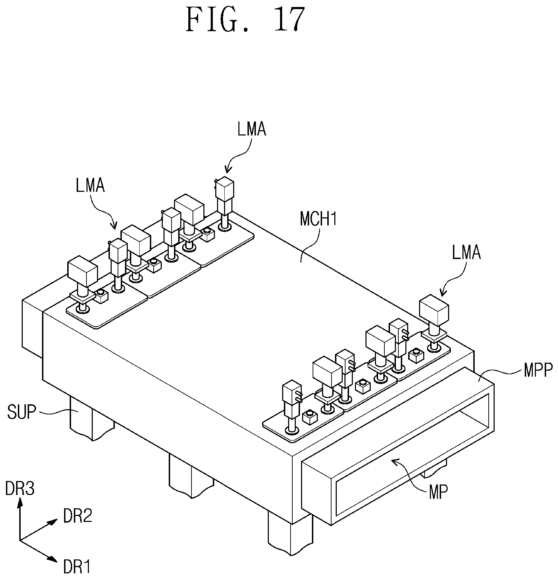

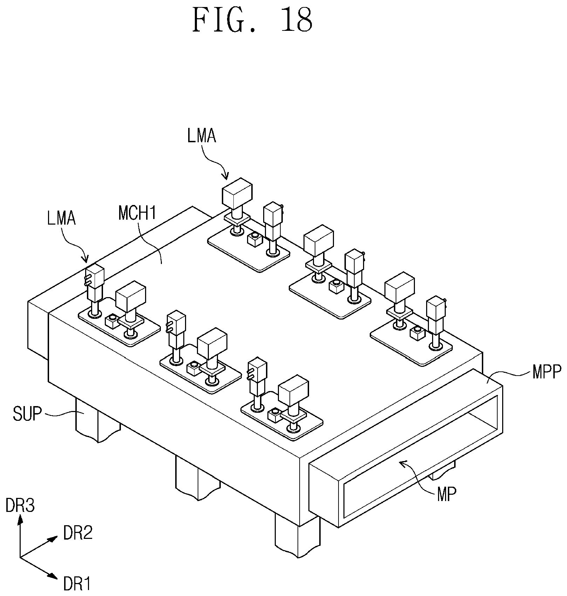

FIGS. 17 and 18 are view illustrating another embodiment of an arrangement of layer thickness measuring devices according to the inventive concept.

FIGS. 17 and 18 illustrate perspective views corresponding to FIG. 11, for example, and hereinafter, the configurations illustrated in FIGS. 17 and 18 will be described mainly with respect to configurations different from those illustrated in FIG. 11.

Referring to FIG. 17, in a plan view, a plurality of layer thickness measuring devices LMA may be arranged along opposite sides of a first transfer chamber MCH1, which are opposite to each other in a first direction DR1 and extend in a second direction DR2. The layer thickness measuring devices LMA may be next (adjacent) to the short sides of the top surface of the first transfer chamber MCH1. The layer thickness measuring devices LMA may be arranged along the short sides of the top surface of the first transfer chamber MCH1.

Referring to FIG. 18, when viewed in the plan view, the plurality of layer thickness measuring devices LMA may be disposed along opposite sides of the first transfer chamber MCH1, which are opposite to each other in the second direction DR2 and extend in the first direction DR1. The layer thickness measuring devices LMA may be next (adjacent) to the long sides of the top surface of the first transfer chamber MCH1. The layer thickness measuring devices LMA may be arranged along the long sides of the top surface of the first transfer chamber MCH1.

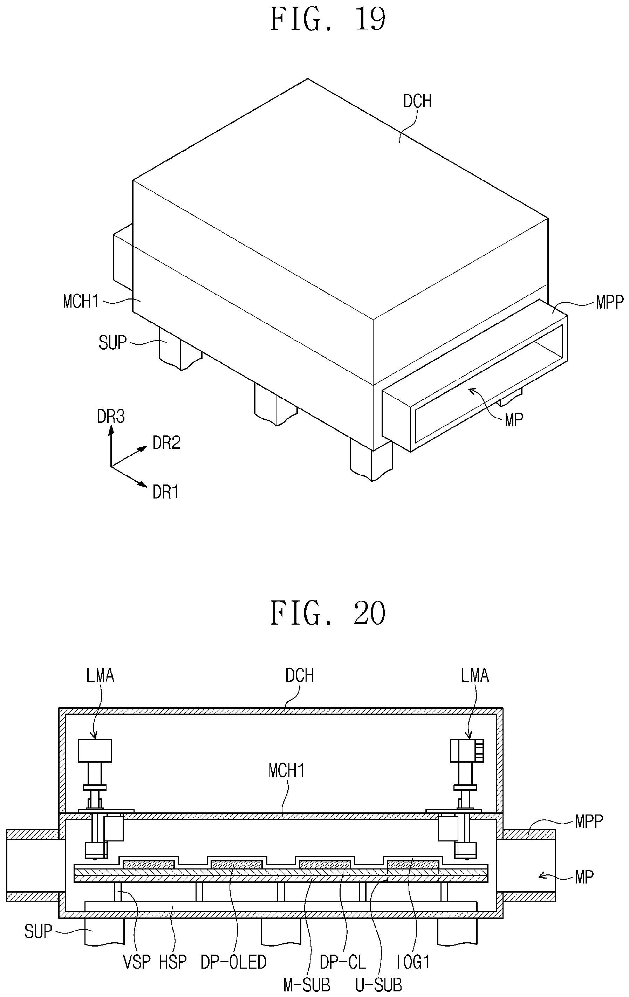

FIG. 19 is a view illustrating another embodiment of a dummy chamber disposed on a transfer chamber according to the inventive concept. FIG. 20 is a view illustrating the inside of the transfer chamber and the dummy chamber illustrated in FIG. 19.

FIG. 20 illustrates a cross-section corresponding to FIG. 13, for example.

Referring to FIGS. 19 and 20, the apparatus DMA for manufacturing the panel may further include a dummy chamber DCH disposed on the first transfer chamber MCH1 to cover the layer thickness measuring devices LMA. The dummy chamber DCH may protect the layer thickness measuring devices LMA without exposing the layer thickness measuring devices LMA to the outside.

By the embodiments of the inventive concept, the first inorganic layer of the thin film encapsulation layer may be formed on the substrate in the first process chamber, and then, the thickness of the first inorganic layer directly in the transfer chamber connected to the first process chamber. The thickness of the next first inorganic layer may be directly connected depending on the thickness of the first inorganic layer, and thus, the first inorganic layers disposed on the substrates may be formed similar to the target thickness.

It will be apparent to those skilled in the art that various modifications and variations may be made in the inventive concept. Thus, it is intended that the disclosure covers the modifications and variations of this invention provided they come within the scope of the appended claims and their equivalents. Thus, to the maximum extent allowed by law, the scope of the invention is to be determined by the broadest permissible interpretation of the following claims and their equivalents, and shall not be restricted or limited by the foregoing detailed description.

## Claims

1. An apparatus for manufacturing a panel including a substrate, a display element layer on the substrate and a first inorganic layer on the display element layer, the apparatus comprising:
a first process chamber configured for deposition of the first inorganic layer on the substrate to cover the display element layer disposed on the substrate;
a second process chamber configured to receive the substrate, on which the first inorganic layer is deposited, and the second process chamber configured for printing an organic layer on the first inorganic layer;
a third process chamber configured to receive the substrate, on which the organic layer is printed, and the third process chamber configured for deposition of a second inorganic layer on the organic layer; and
a layer thickness measuring device which is disposed between the first process chamber and the second process chamber and configured to measure a thickness of the first inorganic layer when the substrate is transferred from the first process chamber to the second process chamber.

2. The apparatus of claim 1, wherein the layer thickness measuring device comprises an ellipsometer.

3. The apparatus of claim 1 or claim 2, further comprising a transfer chamber disposed between the first process chamber and the second process chamber,
wherein the apparatus is configured to transfer the substrate from the first process chamber to the second process chamber through the transfer chamber.

4. The apparatus of claim 3, wherein the layer thickness measuring device is connected to the transfer chamber and configured to measure the thickness of the first inorganic layer on the substrate when disposed within the transfer chamber.

5. The apparatus of claim 4, wherein an upper portion of the layer thickness measuring device is disposed on the transfer chamber, and a lower portion of the layer thickness measuring device is disposed within the transfer chamber.

6. The apparatus of claim 5, further comprising a dummy chamber which is disposed on the transfer chamber and covers the layer thickness measuring device.

7. The apparatus of any of claims 3 to 6, wherein the layer thickness measuring device comprises:
a light generation part which is configured to generate light;
a first lens part which is configured to irradiate the light toward the first inorganic layer;
a second lens part which is configured to receive the light reflected from the first inorganic layer; and
a detection part which is configured to detect an intensity of the reflected light.

8. The apparatus of claim 7, wherein the light generation part and the detection part are disposed on the transfer chamber, and
the first and second lens parts are disposed within the transfer chamber.

9. The apparatus of any of claims 3 to 8, wherein the layer thickness measuring device is configured to measure the thickness of the first inorganic layer, which overlaps a tag disposed on the substrate, and
the first inorganic layer is disposed on the tag.

10. The apparatus of claim 9, wherein the display element layer is disposed on a circuit element layer disposed on the substrate, and the tag is disposed within the circuit element layer, and
in a plan view, the tag does not overlap the display element layer.

11. The apparatus of claim 9 or claim 10, wherein the tag is provided in plural, and the layer thickness measuring device is provided in plural,
wherein a plurality of layer thickness measuring devices overlaps a plurality of tags, respectively.

12. The apparatus of claim 11, further comprising a controller which is configured to calculate the thickness of the first inorganic layer as a mean value of thicknesses measured by the plurality of layer thickness measuring devices.

13. The apparatus of claim 12, (i) wherein, when the thickness of the first inorganic layer is greater than a target thickness, the controller is configured to reduce a deposition amount of next first inorganic layer deposited on a next mother substrate in the first process chamber; and/or
(ii) wherein, when the thickness of the first inorganic layer is less than a target thickness, the controller is configured to increase a deposition amount of next first inorganic layer deposited on a next mother substrate in the first process chamber.

14. The apparatus of any of claims 11 to 13, wherein, in a plan view, the plurality of tags is next to an edge of the substrate, and
the plurality of layer thickness measuring devices are next to an edge of the transfer chamber.

15. The apparatus of any of claims 11 to 14, (i) wherein, in a plan view, the plurality of layer thickness measuring devices is disposed along opposite sides of the transfer chamber, and
the opposite sides of the transfer chamber are opposite to each other in a first direction and extend in a second direction that intersects the first direction; and/or
(ii) wherein, in a plan view, the plurality of layer thickness measuring devices is disposed along opposite sides of the transfer chamber, the opposite sides of the transfer chamber extend in a first direction and are opposite to each other in a second direction that intersects the first direction.
